# EUROPEAN PATENT APPLICATION

(11) **EP 1 235 263 A2**
(43) Date of publication of application: **28.08.2002**
(21) Application number: 02100159.9
(22) Date of filing: 20.02.2002
(51) Int. Cl.: H01L 21/311

(54) **Gas switching during an etch process to modulate the characteristics of the etch**

(30) Priority: 22.02.2001 US 791050
(71) Applicant: Texas Instruments Incorporated, Dallas, Texas 75251 (US)
(72) Inventor: Jiang, Ping, Plano, TX 75024 (US); Celil, Francis G., Dallas, TX 75248 (US)
(74) Representative: Holt, Michael

(57) **Abstract**

Gas switching is used during an etch process to modulate the characteristics of the etch. The etch process comprises a primary step and an secondary step that are repeated at least once. For example, the primary step may result in a high etch rate of oxide (108) while the secondary step results in a low etch rate of oxide and high etch rate of another material (114).

## Description

### TECHNICAL FIELD OF THE INVENTION

The present invention is generally related to the field of semiconductor device fabrication, and more specifically to dual damascene trench etching.

### BACKGROUND OF THE INVENTION

As the density of semiconductor devices increases, the demands on interconnect layers for connecting the semiconductor devices to each other also increase. Therefore, there is a desire to switch from the traditional aluminum metal interconnects to copper interconnects. Unfortunately, suitable copper etches for a semiconductor fabrication environment are not readily available. To overcome the copper etch problem, damascene processes have been developed.

In a conventional interconnect process, the aluminum (and any barrier metals) are deposited, patterned, and etched to form the interconnect lines. Then, an interlevel dielectric (ILD) is deposited and planarized. In a damascene process, the ILD is formed first. The ILD is then patterned and etched. The metal is then deposited over the structure and then chemically-mechanically polished to remove the metal from over the ILD, leaving metal interconnect lines. A metal etch is thereby avoided.

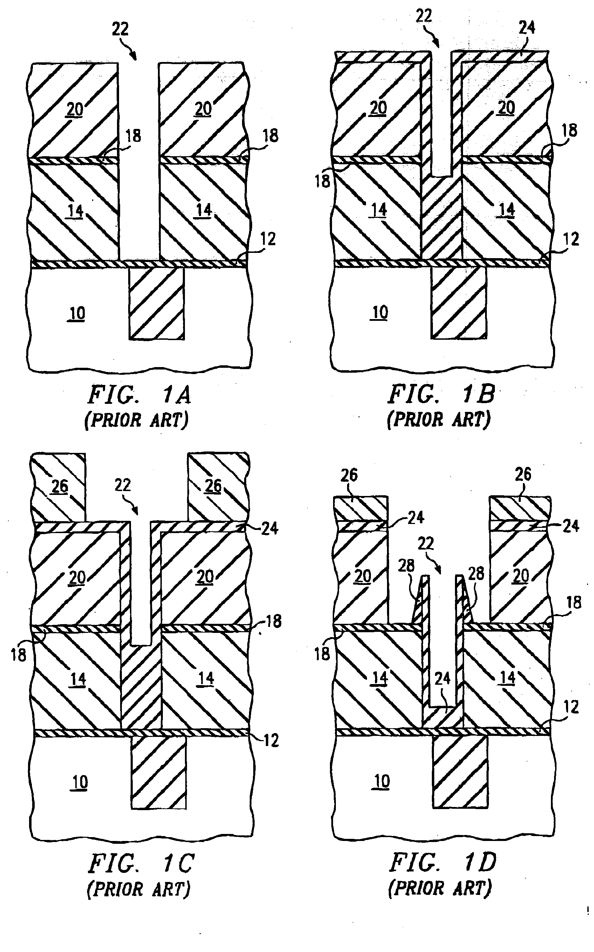

One prior art damascene process, a dual damascene process, is described with reference to FIGs. 1A-E. Referring to FIG. 1A, a silicon nitride layer 12 is deposited over a semiconductor body 10. Semiconductor body 10 will have been processed through a first metal interconnect layer. A via level dielectric 14 is deposited over silicon nitride layer 12. Via dielectric layer 14 comprises FSG (fluorine-doped silicate glass). Another silicon nitride layer 18 is deposited over via level dielectric 14 and a second, trench level dielectric 20 is deposited over silicon nitride layer 18. A via 22 is then patterned and etched through the trench level dielectric 20, silicon nitride layer 18 and via level dielectric 14. Silicon nitride layer 12 is used as a via etch-stop.

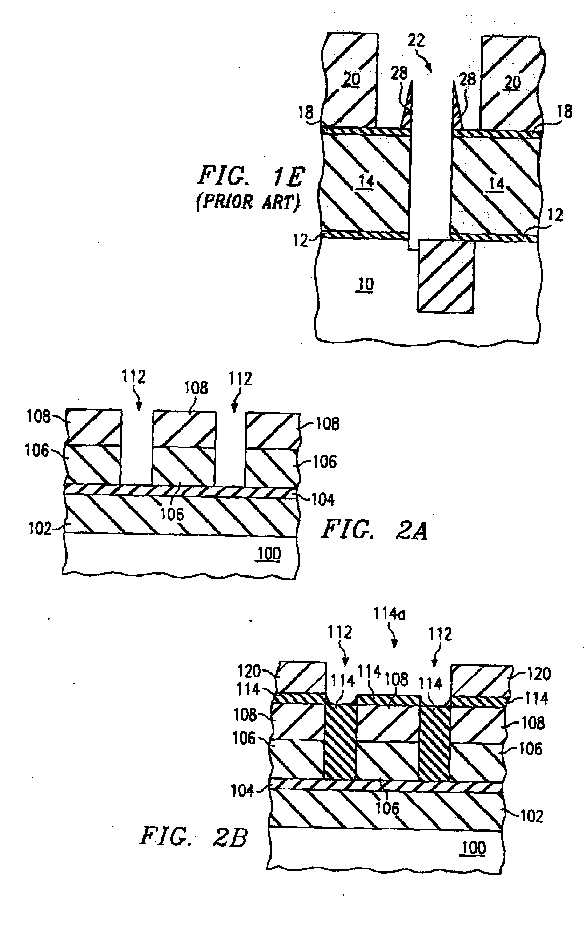

Referring to FIG. 1B, a spin-on organic BARC (bottom anti-reflection coating) 24 is deposited to fill a portion of via 22. The result is approximately 600Å of BARC over dielectric 20 and a thickness of ∼2000-2500Å inside the via 22. BARC 24 protects via 22 during the subsequent trench etch. Next, the trench pattern 26 is formed on the structure as shown in FIG. 1C. Trench pattern 26 exposes areas of trench level dielectric 20 (with about 600Å of BARC on top of dielectric 20) where the metal interconnect lines are desired. Referring to Fig. 1D, the trench etch to remove portions of FSG layer 20 is performed. Oxide ridges 28 may undesirably form on the edges of via 22. Pattern 26 is removed as shown in FIG. 1E. Oxide ridges impair device reliability due to the fact that it is difficult to ensure that a metal barrier completely covers the oxide ridges.

Newer technologies are switching to even lower-k dielectrics such as organo-silicate glass (OSG) in place of FSG. Dual damascene processes for working with the newer dielectrics are needed.

### SUMMARY OF THE INVENTION

The present invention uses gas switching during an etch process to modulate the characteristics of the etch. The etch process comprises a primary step and a secondary step that are repeated at least once. For example, the primary step may result in a high etch rate of oxide while the secondary step results in a lower etch rate of oxide and higher etch rate of another material.

The invention provides an etch process that has a high etch rate, good CD and profile control, high selectivity, and good defect control.

### BRIEF DESCRIPTION OF THE DRAWINGS

For a more complete understanding of the present invention, reference is now made to the following detailed description of certain particular and illustrative embodiments and the features and aspects thereof, by way of example only, and with reference to the figures of the accompanying drawings in which:
FIGs. 1A-1E are cross-sectional diagrams of a prior art dual damascene process at various stages of fabrication;
FIGs. 2A-2E are cross-sectional diagrams of a dual damascene process according to the invention at various stages of fabrication;
FIG. 3 is a cross-sectional diagram of a trench and vias etched according to an embodiment of the invention showing no oxide ridges; and
FIG. 4 is a cross-sectional diagram of trenches etched according to an embodiment of the invention showing good CD and profile.

### DETAILED DESCRIPTION OF THE EMBODIMENTS

The invention will now be described in conjunction with a dual damascene copper interconnect process. It will be apparent to those of ordinary skill having reference to this specification that the benefits of the invention may be applied to other etch applications such as gate etch or contact/via etch to expand process margins and to achieve better etch results.

A fabrication process according to an embodiment of the invention will now be discussed with reference to FIGs. 2A-2E. A semiconductor body 100 is processed through the formation of a first interconnect layer 102 as is known in the art. (Although referred to herein as the first interconnect layer 102, layer 102 may be any interconnect layer except the uppermost interconnect layer.) A via etch-stop layer 104 is deposited over the first interconnect layer 102. Etch-stop layer 104 typically comprises silicon nitride, but other suitable etch-stop layers are known in the art (e.g., SiC). As an example, the thickness of etch-stop layer 104 may be on the order of 1000 Å (e.g., 300Å - 1000Å).

The via level dielectric 106 (sometimes referred to as interlevel dielectric - ILD) and trench level dielectric 108 (sometimes referred to as intrametal dielectric - IMD) are formed over etch-stop layer 104. As shown in FIG. 2A, ILD 106 and IMD 108 can be a single layer. In the preferred embodiment, OSG (organo-silicate glass) is the material used for ILD 106 and IMD 108. OSG is a low-k material having a dielectric constant in the range of 2.7 ∼ 3.0. Alternatively, ILD 106 and IMD 108 may comprise another low-k (k <3.0) or an ultra-low-k (k < 2.7) dielectric. The etch chemistries described hereinbelow are optimized for an OSG dielectric. The combined thickness of ILD 106 and IMD 108 may be approximately 9000Å.

A trench etch-stop layer is not necessary between ILD 106 and IMD 108. However, one could be included if desired. Eliminating the etch-stop layer between the ILD 106 and IMD 108 has the advantage of reducing parasitic capacitance.

Sometimes a capping layer is formed over IMD 108. As an example, oxide capping layer may be deposited using a plasma enhanced tetraethyoxysilane (PETEOS) process. The thickness of oxide capping layer is approximately 1500Å. Silicon nitride could also be used as a capping layer. It should be noted that a BARC layer is often used under the resist for both via and trench pattern. In the preferred embodiment, no capping layer or hardmask is used.

Referring to FIG. 2A, vias 112 are etched through the BARC, IMD 108, and ILD 106. The via etch stops on etch-stop layer 104. Vias 112 are formed in areas where connection is desired between two metal interconnect layers. If an additional etch-stop layer was included between IMD 108 and ILD 106, the via etch also etches through this additional etch-stop layer. In the preferred embodiment, the via etch chemistry comprises C₅F₈, N₂ and CO.

Referring to FIG. 2B, a spin-on BARC 114 is coated to fill at least portion of via 112. FIG. 2B shows a full-fill via. The result is approximately 850Å of BARC over IMD 108 and a thickness of ∼4500Å - 7000 Å inside the via 112 (the BARC thickness inside the via depends on the via density). BARC 114 protects the bottom of via 112 during the subsequent trench etch.

Still referring to FIG. 2B, the trench pattern 120 is formed. Trench pattern 120 exposes the areas where metal interconnect lines of a second or subsequent metal interconnect layer are desired.

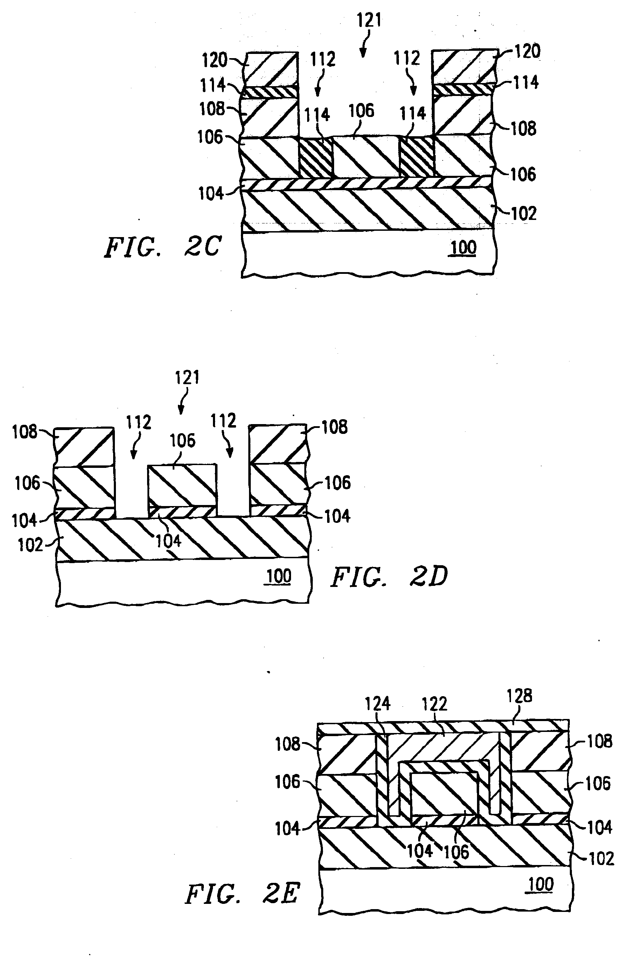

Next, the trench etch is performed to etch IMD 108 as shown in FIG. 2C. The trench etch is a gas switching process to modulate the etch characteristics. The gas switching process uses at least two alternating steps (e.g., a primary and a secondary step) that are repeated at least once. Additional steps may be included and repeated at least once. The primary and secondary steps have differing etch selectivity ratios. In the preferred embodiment, the primary step preferentially etches the IMD while the secondary step preferentially etches the BARC fill and removes ridges. Differing etch selectivity ratios may be obtained by changing one or more of the gases used, changing the flow ratios, or changing the pressure. The remaining process parameters (e.g., power, temp., etc.) may or may not remain the same. In one example, after an initial etch step to remove the exposed portion of BARC layer over IMD 108 (114a), a primary etch step is performed. The primary etch step is tuned to provide a high etch rate for the IMD. A secondary etch step is then performed. The secondary etch step uses a different gas chemistry and is optimized to prevent the formation of oxide ridges that would result from using the primary step alone. For example, the secondary step may have a lower IMD etch rate and higher BARC etch rate or higher inert gas flow. The primary and secondary steps are repeated at least once.

The preferred etch parameters for etching a trench in OSG are given in Table 1. The initial step is used to etch the BARC 114a. The Primary and Secondary steps are repeated 3 times for a total of 45 seconds.

**Table I.**

| Preferred Etch Sequence | | | | | | | |
|---|---|---|---|---|---|---|---|
| Step | Pressure | Power | Gas Species | Gas species | Gas species | Temp. | Time |
| Initial | 40mT | 1400W | 80 CF₄ | 20 O₂ | 160 Ar | 60C/40C | 20s |
| Primary | 40mT | 1500W | 10C₄F₈ | 300 N₂ | 100 Ar | 60C/40C | 10s |
| Secondary | 40mT | 500W | 5 O₂ | 100 N₂ | 400 Ar | 60C/40C | 5s |

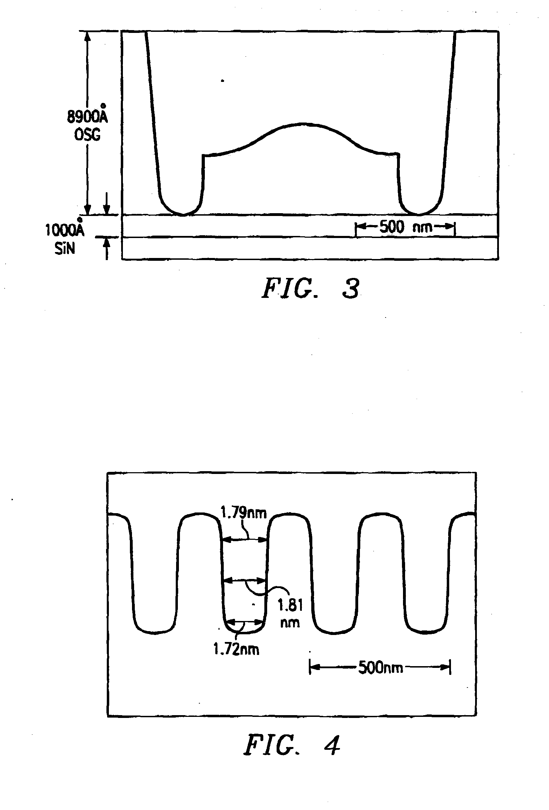

As in the preferred example above, the primary and secondary etch steps may differ by one or more gas species, flow rate, or pressure. The remaining process parameters may or may not remain the same. In the above example, power, flow rate, and time are changed in addition to changing a gas species. The primary etch above has a high etch rate of oxide as in a traditional "etching" step. The secondary etch may be more of an "ashing" with high etch rate of organic BARC inside the vias and low etch rate of oxide and/or "sputtering" with a high flow rate of inert gas to remove ridges. The modulated etch process of Table I can reduce or eliminate oxide ridges with a full BARC-fill of the vias, as shown in FIG. 3. It can also achieve good sidewall profile and CD control for the OSG trench etch, as shown in FIG. 4.

Referring to FIG. 2D, the resist and BARC from trench pattern 120 is removed, for example, by ashing. Next, an etch-stop etch is performed to remove the etch-stop layer at the bottom of the vias. (If the capping layer is thin (e.g., <500A), it can be removed during etch-stop layer etch. However, if the capping layer is >500A, it is removed during metal CMP.)

Processing then continues with the formation of the second metal interconnect layer 122, as shown in FIG. 2E. (Although referred to as the second metal interconnect layer, layer 122 can be any metal interconnect layer other than the lowest interconnect layer.) Typically, a barrier layer 124, such as tantalum-nitride (TaN) is deposited first. Due to the fact that no oxide ridges are formed, it is fairly easy to form a continuous barrier layer 124 in the trench/via. This advantage also increases the process margin. The purpose of the barrier layer is to prevent diffusion of the subsequently formed metal into the IMD/ILD. Breaks in the barrier layer allow metal diffusion and thus reduce yield and reliability. The invention thus improves both the yield and reliability by preventing the formation of oxide ridges and reducing defects in the via.

After the barrier layer 124 is deposited, a copper seed layer is typically formed. This is followed by the formation of the copper interconnect 122 and a top nitride (Si₃N₄) capping layer 128. The above process can then be repeated to form subsequent metal interconnect layers.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. For example, the etch chemistries of the primary and secondary steps may be reversed such that the primary step etches BARC faster and the secondary step etches OSG faster.

## Claims

1. A method for fabricating an integrated circuit, comprising:
providing a semiconductor body having a layer formed thereover;
forming a pattern over said layer; and
etching said layer using a process having at least a primary step and a secondary step, wherein said primary step and secondary step are repeated at least once.

2. The method of claim 1, wherein said primary step uses a first gas chemistry and said secondary step uses a second, distinct, gas chemistry.

3. The method of claim 2, wherein said first gas chemistry provides a higher etch rate for said layer and said second gas chemistry provides a lower etch rate for said layer.

4. The method of claim 2, wherein said primary step uses a first power and said secondary step uses a second, distinct power.

5. The method of claim 1, wherein said primary step comprises a first flow ratio of process gases and said secondary step comprises a second, distinct, flow ratio of process gases.

6. The method of claim 1, wherein said primary step occurs at a first pressure and said secondary step occurs at a second, distinct, pressure.

7. The method of claim 1, wherein said etch process comprises at least one additional step that is repeated at least once.

8. The method of any preceding claim, wherein said step of providing said semiconductor body comprises providing a semiconductor body having an interlevel dielectric (ILD) and intrametal dielectric (IMD) formed thereover.

9. The method of claim 8, further comprising:
etching a via in said ILD and in said IMD; and
filling said via with a BARC material.

10. The method of claim 9, wherein said step of forming said pattern comprises forming a trench pattern over said IMD.

11. The method of claim 10, wherein said etching step comprises etching a trench in said IMD using a process having at least a primary step and a secondary step, wherein said primary step and secondary step are repeated at least once.

12. The method of any of claims 8-11, wherein said IMD and ILD each comprise organo-silicate glass.

13. The method of claim 12, wherein said first gas chemistry etches said organo-silicate glass at a higher rate than said second gas chemistry and said second gas chemistry etches said BARC material faster than the organo-silicate glass and removes any oxide ridges.

14. The method of claim 12 or claim 13, wherein said first gas chemistry comprises C₄F₈, nitrogen, and argon and said second gas chemistry comprises O₂ and one or more gases selected from the group consisting of nitrogen and argon.

15. The method of claim 14, wherein said first gas chemistry etches the BARC material at a higher rate than said second gas chemistry, and said second gas chemistry etches said organo-silicate glass faster than the BARC material.
